# EUROPÄISCHE PATENTSCHRIFT

(11) **EP 1 050 596 B1**
(45) Veröffentlichungstag und Bekanntmachung des Hinweises auf die Patenterteilung: **07.09.2005**
(21) Anmeldenummer: 00107652.0
(22) Anmeldetag: 10.04.2000
(51) Int. Cl.: C23C 14/24, C23C 14/30

(54) **Elektronenstrahlverdampfer für Vacuum-Beschichtungsanlagen**
Electron beam evaporator for vacuum coating apparatus
Evaporateur à faisceau électronique pour dispositif de revêtement sous vide

(30) Priorität: 04.05.1999 CH 81999
(43) Veröffentlichungstag der Anmeldung: 08.11.2000
(73) Patentinhaber: Satis Vacuum Industries Vertriebs - AG, 6341 Baar (CH)
(72) Erfinder: Siegrist, Beat, 8704 Herrliberg (CH)
(74) Vertreter: Petschner, Goetz

(56) Entgegenhaltungen:
- US-A- 4 700 660
- PATENT ABSTRACTS OF JAPAN vol. 012, no. 333 (C-526), 8. September 1988 (1988-09-08) & JP 63 093855 A (MITSUBISHI ELECTRIC CORP), 25. April 1988 (1988-04-25)
- PATENT ABSTRACTS OF JAPAN vol. 014, no. 294 (C-0732), 26. Juni 1990 (1990-06-26) -& JP 02 093063 A (MITSUBISHI HEAVY IND LTD), 3. April 1990 (1990-04-03)

## Beschreibung

Die vorliegende Erfindung betrifft einen Elektronenstrahlverdampfer für Vacuum-Beschichtungsanlagen, mit mindestens einem Tiegel zur Aufnahme eines Liners (Napf) mit einem aufzudampfenden Material.

Bei Anlagen insbesondere zur Beschichtung optischer Substrate, unter Vakuum, welche einen gasdicht verschliessbaren, evakuierbaren und mit einer Atmosphäre aus inertem Gas versehbaren Vakuum-Arbeitsbehälter (Rezipienten) umfassen, kommt der lagegenauen Anordnung der auswechselbaren Liner mit dem jeweiligen Aufdampfmaterial im Tiegel eine wesentliche Bedeutung zu, um ein qualitativ hochstehendes Beschichtungsergebnis zu erreichen.

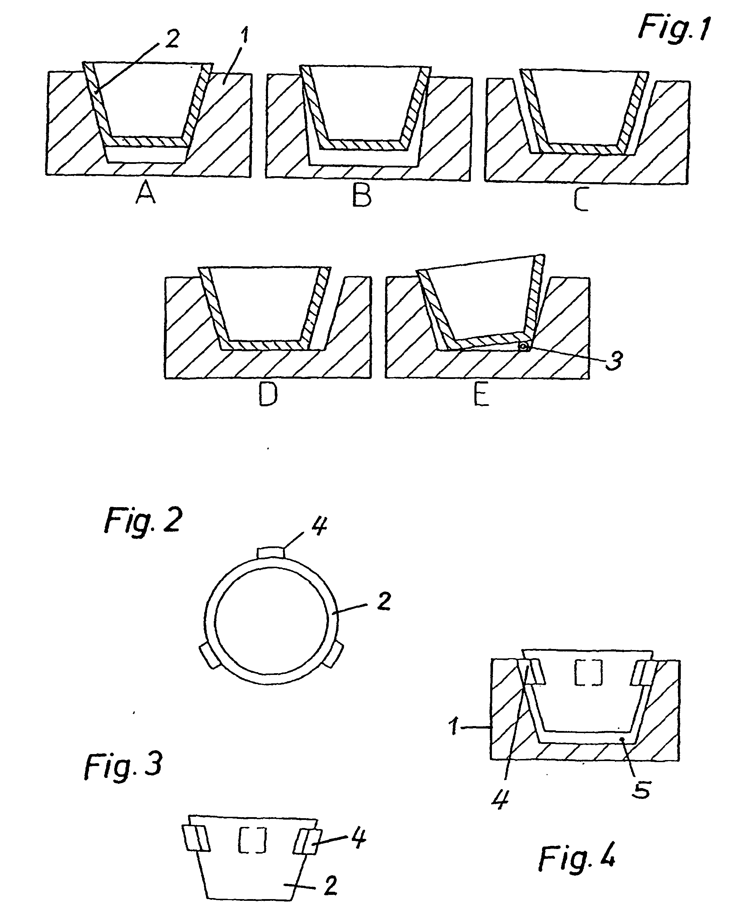

Eine lagegenaue Anordnung der auswechselbaren Liner mit dem jeweiligen Aufdampfmaterial im Tiegel ist aber gemäss bisherigem Stand der Technik nicht möglich, wie das die Fig. 1A bis 1E zeigen. Die dabei erkennbaren undefinierten Lagen zwischen dem relativ kalten Kupfer-Tiegel 1 und dem auswechselbaren relativ heissen Liner 2 mit dem jeweiligen Aufdampfmaterial erzeugen eine stark schwankende und unkontrollierbare Temperaturverteilung am Liner.

Nachteilig ist dadurch eine unregelmässige Verdampfung und unregelmässige Wärmeabstrahlung, was zu ungenügenden Bedampfungsschichten am zu bedampfenden Substrat führt. Ferner kommt es vermehrt zu Überlaufmaterial 3 (Fig. 1E), das beim Ausgasen die Lage des Liners im Tiegel während der Bedampfung verändern kann. Hohe Temperaturschwankungen am Liner führen zudem zu thermo-mechanischen Spannungen, welche die Lebensdauer solcher Liner wegen Wandungsbrüche erheblich vermindern.

Es ist deshalb Aufgabe der vorliegenden Erfindung, eine lagegenaue Anordnung der auswechselbaren Liner mit dem jeweiligen Aufdampfmaterial im Tiegel zu schaffen, die zu einem gleichbleibenden qualitativ hochstehenden Beschichtungsergebnis führt.

Dies wird erfindungsgemäss dadurch erreicht, dass dass der Liner über Abstandsmittel zentrisch sowie umfänglich und gegebenenfalls auch bodenseitig mit vorgegebenem Abstand distanziert im Tiegel abgestützt ist, wobei die Abstandsmittel von der Aussenwandung des Liners oder von der Innenwandung des Tiegels abragende, am Umfang verteilte Nocken oder Rippen oder durch eine umgreifende Abragung gebildet sind.

Durch diese Massnahmen wird eine eindeutige und wiederholbare lagegenaue Anordnung des Liners im Tiegel erreicht, was eine regelmässige Verdampfung und regelmässige Wärmeabstrahlung und somit eine qualitativ hochstehende Bedampfungsschicht am zu bedampfenden Substrat gewährleistet. Ferner lässt der definierte Abstand zwischen Liner und Tiegel eine ungehinderte und somit druckfreie Ausgasung von allfälligem Überlaufmaterial zu. Weiter werden thermo-mechanische Spannungen soweit ausgeschlossen, dass sich die Lebensdauer solcher Liner um ein Mehrfaches erhöhen lässt.

Mögliche Ausführungsformen im Rahmen der Erfindung sind dabei u.a., dass die Abstandsmittel von der Aussenwandung des Liners oder von der Innenwandung des Tiegels abragende, am Umfang verteilte Nocken oder Rippen sind oder durch eine umgreifende Abragung gebildet sind, ferner, dass die Abstandsmittel in Gegennuten formschlüssig eingreifen.

Eine Ausführungsform des Erfindungsgegenstandes ist nachfolgend anhand der Zeichnung näher erläutert. Es zeigen:
- Fig. 1A bis 1E: einen Liner in einem Tiegel des Standes der Technik, im Schnitt, mit verschiedenen undefinierten Lagen zwischen Tiegel und dem auswechselbaren Liner; und
- Fig. 2 bis 4: in Drauf- und Seitenansicht einen Liner resp. im Schnitt einen Liner in einem Tiegel gemäss der vorliegenden Erfindung.

Wie bereits vorbeschrieben, ist eine lagegenaue Anordnung der auswechselbaren Liner 2 mit dem jeweiligen Aufdampfmaterial im Tiegel 1 mit den bekannten Anordnungen gemäss den Fig. 1A bis 1E nicht möglich.

Solche Tiegel und damit auch die zugeordneten Liner können dabei von beliebiger Konfiguration sein. In der Regel sind solche Tiegel und entsprechend die Liner zylindrisch mit konisch zulaufender Wandung.

Gemäss Fig. 2 bis 4 besteht nun erfindungsgemäss eine lagegenaue Anordnung der auswechselbaren Liner mit dem jeweiligen Aufdampfmaterial im Tiegel darin dass der Liner 2 über Abstandsmittel 4 zentrisch sowie umfänglich und gegebenenfalls auch bodenseitig mit vorgegebenem Abstand 5 distanziert im Tiegel 1 abgestützt ist.

Hierbei können die Abstandsmittel 4 von der Aussenwandung des Liners 2 oder von der Innenwandung des Tiegels 1 abragende, am Umfang verteilte Nocken oder Rippen sein oder sind durch eine umgreifende Abragung gebildet.

Weiter können die Abstandsmittel 4 in Gegennuten formschlüssig eingreifen (nicht gezeigt).

Wie erkennbar, wird so eine eindeutige und wiederholbare lagegenaue Anordnung des Liners im Tiegel erreicht, was eine regelmässige Verdampfung und regelmässige Wärmeabstrahlung und somit eine qualitativ hochstehende Bedampfungsschicht am zu bedampfenden Substrat gewährleistet.

Ferner lässt der definierte Abstand zwischen Liner und Tiegel eine ungehinderte und somit druckfreie Ausgasung von allfälligem Überlaufmaterial zu. Weiter werden thermo-mechanische Spannungen soweit ausgeschlossen, dass sich die Lebensdauer solcher Liner um ein Mehrfaches erhöhen lässt.

## Patentansprüche

1. Elektronenstrahlverdampfer für Vacuum-Beschichtungsanlagen, mit mindestens einem Tiegel zur Aufnahme eines Liners (Napf) mit einem aufzudampfenden Material
**dadurch gekennzeichnet,**
**dass** der Liner (2) über Abstandsmittel (4) zentrisch sowie umfänglich und gegebenenfalls auch bodenseitig mit vorgegebenem Abstand (5) distanziert im Tiegel (1) abgestützt ist, wobei die Abstandsmittel (4) von der Aussenwandung des Liners (2) oder von der Innenwandung des Tiegels (1) abragende, am Umfang verteilte Nocken oder Rippen oder durch eine umgreifende Abragung gebildet sind.

2. Elektronenstrahlverdampfer nach Anspruch 1, **dadurch gekennzeichnet, dass** die Abstandsmittel (4) in Gegennuten formschlüssig eingreifen.

## Claims

1. Electron beam evaporator for vacuum coating apparatus with at least one crucible to receive a liner containing the material to be vaporized,
**characterized in that**
the liner (2) is centered at a set distance (5) from the crucible (1) by spacers (4) around its perimeter and possible against its base,
whereby the spacers (4) are formed by bumps or ribs that extend from and are distributed over the outer wall of the liner (2) or the inner wall of the crucible (1), or the spacer can be a surrounding projection.

2. Electron beam evaporator according to claim 1, **characterized in that** the spacers (4) key into opposing grooves.

## Revendications

1. Evaporateur à faisceau électronique pour dispositifs de revêtement sous vide, avec au moins un creuset pour la réception d'une chemise (godet) avec le matériau à métalliser sous vide,
**caractérisé**
**en ce que** la chemise (2) est supportée par des moyens d'écartement (4) centralement et au pourtour et le cas échéant également au côté du fond, en étant espacée selon un écart prédéterminé (5) dans le creuset (1), où les moyens d'écartement (4) sont formés par des ergots ou nervures répartis sur le pourtour ou par une saillie s'étendant tout autour, faisant saillie de la paroi extérieure de la chemise (2) ou de la paroi intérieure du creuset (1).

2. Evaporateur à faisceau électronique selon la revendication 1, **caractérisé en ce que** les moyens d'écartement (4) s'engagent par concordance des formes dans des contre-rainures.
